# EUROPEAN PATENT APPLICATION

(11) **EP 0 559 092 A1**
(43) Date of publication of application: **08.09.1993**
(21) Application number: 93103059.7
(22) Date of filing: 26.02.1993
(51) Int. Cl.: H01L 23/373

(54) **Metal foam heat dissipator**

(30) Priority: 05.03.1992 US 846650
(71) Applicant: TEXAS INSTRUMENTS INCORPORATED, Dallas Texas 75265 (US)
(72) Inventor: McLellan, Robert N., Garland, TX 75044 (US)
(74) Representative: Schwepfinger, Karl-Heinz, Dipl.-Ing.

(57) **Abstract**

A porous metallic foam (32) is used in combination with a heat spreader (31) as a heat sink/dissipator for semiconductor devices (30).

## Description

### FIELD OF THE INVENTION

This invention relates to semiconductor devices, and more particularly to a metallic foam heat, dissipator for semiconductor devices.

### BACKGROUND OF THE INVENTION

Traditional methods of heat dissipation for semiconductor devices and integrated circuits has included the use of pin fin or stacked plate heat dissipators on the package backside. Stacked plate and pin dissipators, while effective, require more bulk for heat dissipation than equivalent foam dissipators. The performance of these dissipators depends on the surface area and the thermal conductivity of the device and the heat dissipators as well as the ambient temperature and air flow rate around the device.

### BRIEF SUMMARY OF THE INVENTION

The invention is to a semiconductor device utilizing a metallic foam as a heat dissipator. The heat transfer characteristics depends upon the effective dissipation area of the foam. The dissipation area of the foam is dependent upon the number of pores per square inch of the foam. A foam dissipator of 20 pores per inch provides adequate surface area and permits sufficient air flow though the dissipator for most devices.

The metallic foam is secured to a heat spreader attached to the semiconductor device with a thermal transmissive adhesive.

The technical advance represented by the invention as well as the objects thereof will become apparent from the following description of a preferred embodiment of the invention when considered in conjunction with the accompanying drawings, and the novel features set forth in the appended claims.

### BRIEF DESCRIPTION OF THE DRAWINGS

FIGURE 1 illustrates a prior art pin fin heat sink;
FIGURE 2 illustrates a prior art stacked plated heat sink;
FIGURE 3 illustrates a metallic foam heat sink; and
FIGURE 4 is a table showing the effective Degree per C/watt vs air flow for a metallic foam heat sink and a plate heat sink.

### DESCRIPTION OF A PREFERRED EMBODIMENT

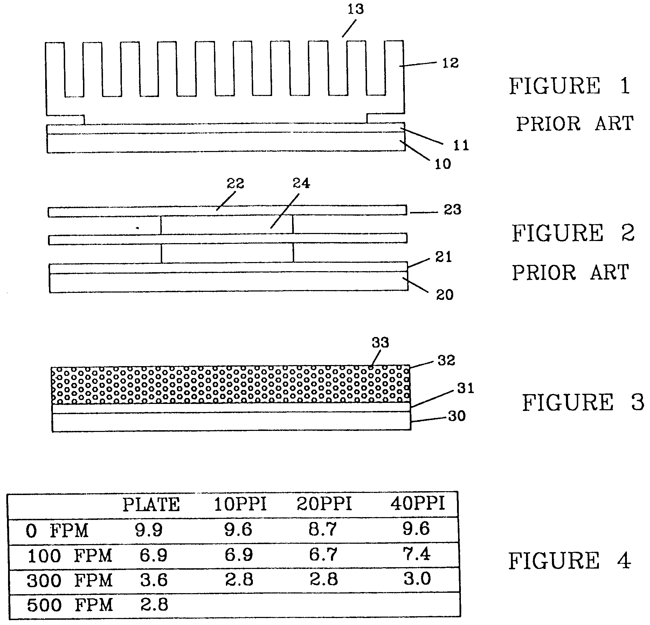

Figure 1 illustrates a pin fin heat sink. A semiconductor device 10 has a heat spreader plated 11 attached to its top surface. The pin fin heat sink 12 has a plurality of fins 13 extending vertically up form the main body 12 of the heat dissipator.

Figure 2 illustrates a stacked plate heat dissipator. Semiconductor 20 has a heat spreader plate 21 secured to the top surface of the device. The stacked plated dissipator 22 has a plurality of stacked plates 23 and 24. Plates 24 are smaller plates than plates 23. This provides a greater area for heat dissipation.

Figure 3 is an embodiment of the invention in which a metallic foam is used as the heat dissipator. Metal foam is available commercially from several sources. A semiconductor device 30 has a heat spreader 31 attached to its top surface. Heat spreader 31 may be, for example, a aluminum or copper plate on top of the heat spreader is a metallic foam heat dissipator 32. Foam dissipator 32 has a large number of pores in the surface and extending into the body of the dissipator. The foam dissipator resembles a sponge in which the pores extend through out the body of the foam dissipator. The pores in the surface and interior of the dissipator provides an extremely high surface area per unit volume of the metallic foam.

In one example the heat spreader 31 was aluminum of about 50 mill thickness, and the foam was about 250 mills thick.

Figure 4 is a table showing a comparison of a plate heat sink and the metallic foam heat sink. The foam heat sink was 1.8" square by .30" high. The plate was 2" square by .32" high. Varying amounts of air was flowed across the heat sink using sideways air flow. Measurements were taken with 0, 100, 300 and 500 feet per minute of air flow. Metallic foam heat sinks were used with 10, 20 and 40 pores per inch. The measured number represents degrees centigrade per watt of dissipation of the device.

For example, a 4 watt device, using a plate heat sink/dissipator was 9.9 x 4 39.6 degrees Centigrade above the ambient temperature. For a 20 PPI foam dissipator, the device was at 8.7 x 4 = 34.8 degrees Centigrade above ambient temperature. This was for no air flow across the devices. With an air flow of 300 FPM, the device using the plate dissipator was at 14.4 degrees Centigrade above the ambient temperature. The device using the metallic foam dissipator was 10.4 degrees Centigrade above the ambient temperature. This is an improvement of 4 degrees centigrade through the use of the metallic foam dissipator.

## Claims

1. A heat dissipator for a semiconductor device, comprising a heat spreader attached to a surface of the semiconductor device, and a metallic foam attached to the heat spreader.

2. The heat dissipator according to claim 1, wherein said metallic foam is a thermally conductive metal.

3. The heat dissipator according to claim 1 or claim 2, wherein said heat spreader is a thermally conductive metal.

4. The heat dissipator according to any preceding claim, wherein said metallic foam is attached to said heat spreader with a thermal conductive adhesive.

5. The heat dissipator according to any of claims 1 to 3, wherein said metallic foam is brazed to said heat spreader.

6. The heat dissipator according to any preceding claim, wherein said metallic foam has a porosity in the range from 5 to 50 pores per inch.

7. The heat dissipator according to any preceding claim, wherein the metallic foam comprises a porous aluminium foam.
